# EUROPEAN PATENT SPECIFICATION

(11) **EP 0 382 163 B1**
(45) Date of publication and mention of the grant of the patent: **03.11.1993**
(21) Application number: 90102305.1
(22) Date of filing: 06.02.1990
(51) Int. Cl.: H05K 7/20

(54) **A reservoir tank for a liquid cooling system**
Tank für ein Flüssigkeitskühlungssystem
Un réservoir pour un système de refroidissement par liquide

(30) Priority: 06.02.1989 JP 26861/89
(43) Date of publication of application: 16.08.1990
(73) Proprietor: FUJITSU LIMITED, Kawasaki-shi, Kanagawa 211 (JP)
(72) Inventor: Takemae, Motohiro, c/o Fujitsu Limited, Nakahara-ku, Kawasaki-shi, Kanagawa, 211 (JP); Kanki, Takaaki, c/o Fujitsu Limited, Nakahara-ku, Kawasaki-shi, Kanagawa, 211 (JP); Takao, Hirofumi, c/o Fujitsu Limited, Nakahara-ku, Kawasaki-shi, Kanagawa, 211 (JP); Kawashima, Hisashi, c/o Fujitsu Limited, Nakahara-ku, Kawasaki-shi, Kanagawa, 211 (JP); Katsumi, Hideo, c/o Fujitsu Limited, Nakahara-ku, Kawasaki-shi, Kanagawa, 211 (JP)
(74) Representative: Sunderland, James Harry

(56) References cited:
- EP-A- 0 075 175
- EP-A- 0 313 473
- US-A- 3 774 677

## Description

This invention relates to a reservoir tank, for coolant in a liquid cooling system.

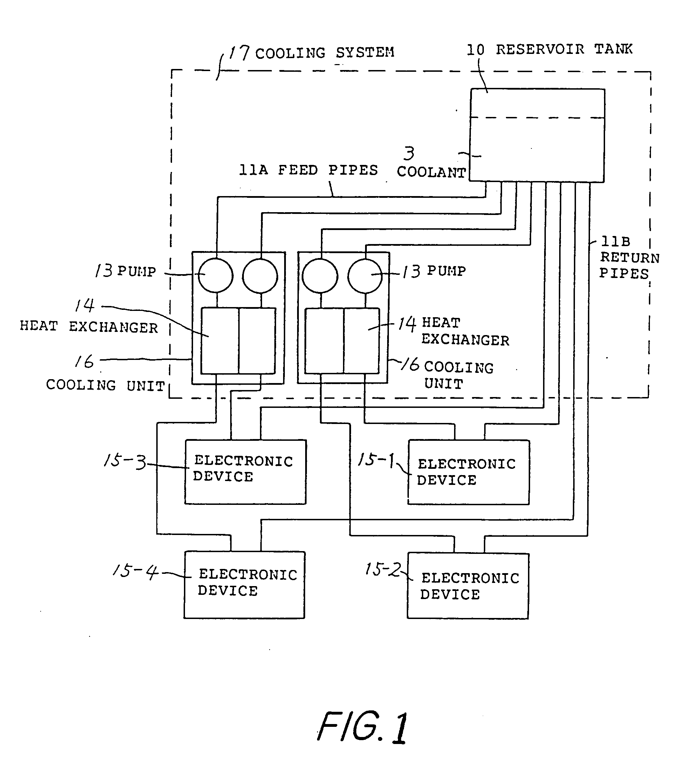

Recently, a cooling system in which cooling is carried out by circulation of coolant, such as cooled water, has been used for absorbing heat generated in electronic apparatus formed with electronic components such as semiconductor devices. It has been proposed to structure such a cooling system for example as shown in Fig. 1. In order to cool a plurality of electronic devices 15-1 to 15-4, a cooling system 17 comprising a plurality of cooling units 16, each of which is composed of pumps 13 for feeding coolant 3 and heat exchangers 14 for cooling the coolant 3 to a predetermined temperature, are provided. The coolant 3, reserved in a reservoir tank 10, is fed to the respective cooling units 16 through a plurality of feed pipes 11A; the coolant 3 cooled to a predetermined temperature by the heat exchangers 14 is supplied to the electronic devices, for instance LSI (large-scale integrated circuit) devices from the cooling units 16; and the coolant 3 which has cooled the electronic devices 15-1 to 15-4 is returned to the reservoir tank 10 through a plurality of return pipes 11B. The provision of cooling units 16 can be expanded as required depending on the installed number of the electronic devices 15-1 to 15-4. Therefore, the reservoir tank 10 is commonly provided with a plurality of feed pipes 11A and return pipes 11B for the coolant. In such a structure where the cooling is carried out by feeding the coolant 3, cooled down to the predetermined temperature, to the electronic devices 15-1 to 15-4, it is essential to keep the temperature of coolant 3 to be fed from each cooling unit 16 at a temperature lower than a specified temperature, in order to reliably provide sufficient cooling of the electronic devices 15-1 to 15-4. However, since the heat exchanging capacity of such a cooling unit 16 is limited, if the temperatures of coolant 3 as supplied from the reservoir tank 10 to the respective cooling units 16 are not equal, the temperatures of coolant 3 as fed from the respective cooling units 16 are inevitably not equal. Accordingly, the coolant 3 fed to each of the electronic devices 15-1 to 15-4 may no longer be cooled below the predetermined temperature, and thus some electronic devices may not be sufficiently cooled.

Therefore, it is desired to constitute a cooling unit in which the temperatures of the coolant 3 supplied via the plurality of feed pipes 11A from the reservoir tank 10 are equal so that the coolant 3 to be supplied from the cooling unit 16 is always kept at a predetermined temperature or lower. However, a conventional reservoir tank 10 suffers the following problem.

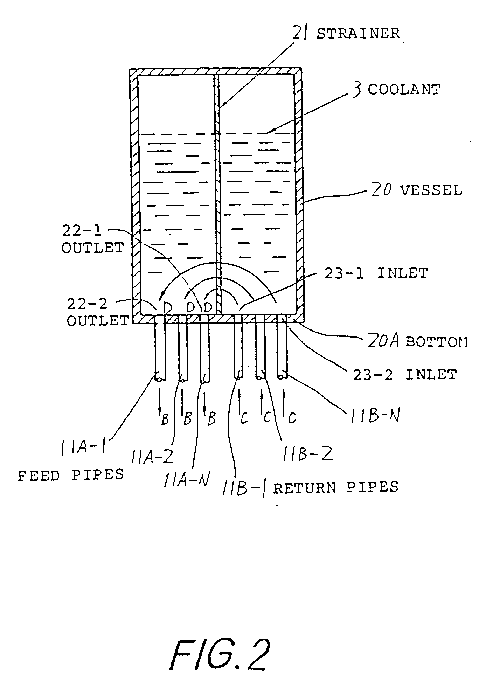

A typical example of a conventional reservoir tank is shown in the side elevational sectional view of Fig. 2. A bottom 20A of a cylindrical vessel 20 is provided with a plurality of outlets 22 and inlets 23. The outlets 22 are connected with feed pipes 11A-1 to 11A-N, respectively, while the inlets 23 are connected with return pipes 11B-1 to 11B-N. At the centre of the vessel 20, a strainer 21 is provided for removing undesirable particles in the coolant. Coolant 3 returned as indicated by arrows C via the inlets 23 and the return pipes 11B-1 to 11B-N, is reserved or held in the reservoir tank 20 and the coolant 3 filtered by the strainer 21 is output as indicated by arrow marks B via the outlets 22 and the feed pipes 11A-1 to 11A-N. Therefore, in such a structure, distance between the inlet 23-1 and the outlet 22-1, both provided in the vicinity of the centre of vessel 20, is extremely small whilst distance between the inlet 23-2 and the outlet 22-2, both provided in the vicinity of the wall of vessel 20, is very large. Further, since the heat loads of the electronic devices 15-1 to 15-4 are not always equal, temperature differences may be generated in coolant as returned via different inlets 23. In this case, temperature of coolant output from outlet 22-1 is influenced very much by the temperature of the coolant returned to inlet 23-1. On the other hand, temperature of coolant output from outlet 22-2, far from the inlet 23-2, is not influenced so much by the temperature of coolant returned to inlet 23-2. Accordingly, non-equal temperatures of coolant returned through the plurality of inlets cause temperature differences in coolant output from each of the plurality of outlets. Therefore, there is a problem in that some coolant temperatures of coolant outputs from cooling units 16 do not achieve values below the predetermined value. Consequently, uniform cooling cannot be realised.

From EP-A-0 313 473, which falls under Article 54(3) EPC and is therefore not relevant to the question of inventive step, there is further known an apparatus for supplying cooling fluid in which the main supply pipe is connected to and opened at the center of the bottom wall of a mixing tank. On the other hand, a plurality of return pipes are connected to the bottom wall of the mixing tank and arranged to open therearound; such an arrangement of the main supply pipe and the plurality of return pipes being effective to promote the mixing of the cooling water in the mixing tank.

The present invention as claimed provides a reservoir tank into which coolant is returned via a plurality of inlets which provides that temperature of coolant output from a plurality of outlets is kept more uniform.

A reservoir tank in accordance with the present invention as defined in claim 1 is so structured that feed outlets are provided towards the centre of a bottom or base of a vessel and so that in coolant reserved or held in the reservoir tank (vessel) a whirlpool effect is generated in a predetermined direction of flow in response to coolant returned from return inlets, the inlets being arranged outwardly of the outlets and being directed so as to be inclined with respect to a vertical line or axis extending perpendicularly to the bottom or base into the reservoir tank in order to generate the whirlpool effect in the coolant.

According to the present invention there is further provided a liquid cooling system as defined in Claim 7.

Reference is made, by way of example, to the accompanying drawings, in which:-
Fig. 1 schematically illustrates a configuration of a liquid cooling system;
Fig. 2 is a side elevational sectional view of a previously proposed reservoir tank to be used in the cooling system of Fig. 1;
Fig. 3 is a side elevational sectional view indicating in a general way features of a reservoir tank in accordance with an embodiment of the present invention;
Fig. 4 is a side elevation of a reservoir tank embodying the present invention;
Fig. 5 is a side elevational sectional view of the embodiment of the present invention shown in Fig. 4; and
Fig. 6 is a sectional view taken along line H-H in Fig. 5.

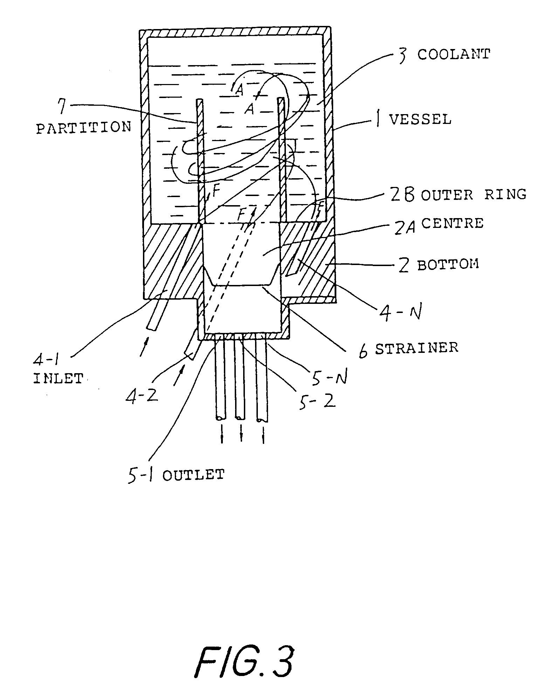

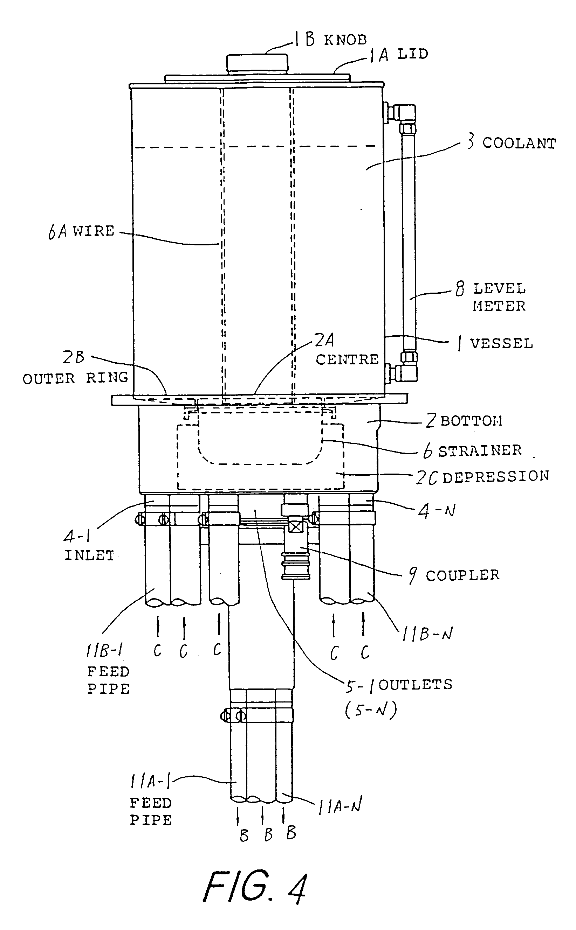

A reservoir tank 10 according to an embodiment of the present invention will be explained in detail with reference to the diagram of Fig. 3, which illustrates features in a general sense, and to Figs. 4 to 6. Like or similar elements are designated by like reference signs throughout these Figures.

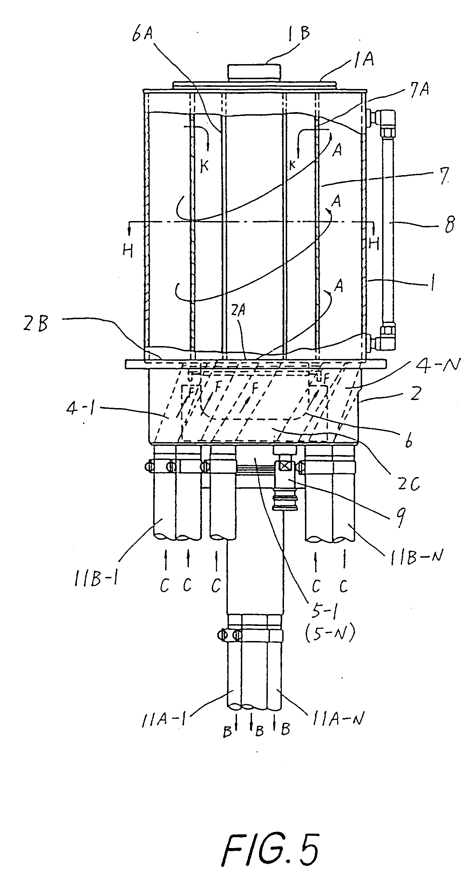

The reservoir tank 10 is basically composed of a cylindrical vessel 1 and its bottom or base 2. A depression 2C (Figs. 4 and 5) formed at the centre 2A of the bottom 2 of the cylindrical vessel 1, in which coolant, for example water, is held or reserved, is provided with a strainer 6 and a plurality of outlets 5-1 to 5-N connected with a plurality of feed pipes 11A-1 to 11A-N (Figs. 4 and 5). An outer ring 2B of the bottom 2 is provided with a plurality of inlets 4-1 to 4-N connected respectively to a plurality of return pipes 11B-1 to 11B-N (Figs. 4 and 5). Coolant 3, returned as indicated by the arrows C from the return pipes 11B-1 to 11B-N (Figs. 4 and 5), is reserved or held in the vessel 1, the reserved coolant 3 is then filtered by the strainer 6 for elimination of undesirably contained particles and is then output as indicated by arrows B from the feed pipes 11A-1 to 11A-N (Figs. 4 and 5). A level meter 8 (Figs. 4 and 5) is provided at the side of the vessel 1 for monitoring the amount of coolant 3 reserved or held within the vessel 1. On its top, a lid 1A mountable by a knob 1B (Figs. 4 and 5) is provided for additional supply of coolant 3. The lid 1A is provided with a stationary wire 6A (Figs. 4, 5 and 6) and an end of the wire 6A is engaged with the strainer 6. When the strainer 6 is clogged, the strainer 6 can be cleaned after being removed by removing the lid 1A.

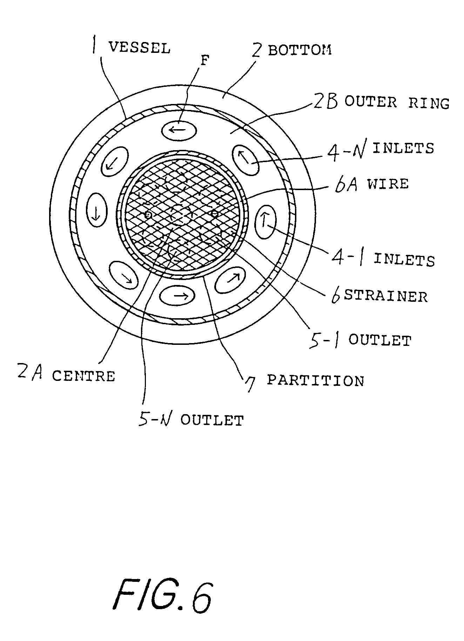

As shown in Figs. 3, 5 and 6, within the vessel 1, a cylindrical partition 7 is provided for partitioning the centre or central portion 2A of the bottom 2, which central portion has the outlets 5-1 to 5-N, from the outer ring 2B of the bottom 2, which outer ring has the inlets 4-1 to 4-N. As shown in Fig. 6, the inlets 4-1 to 4-N provided at the outer ring 2B are arranged around a circle. The respective inlets 4-1 to 4-N are provided with inclinations in the direction of arrows F as shown in Fig. 5 (see also Figs. 3 and 6), from the vertical line of tank 10. Moreover in Fig. 6, the arrows F indicate the direction of inclination of the respective inlets. Coolant 3 flowing into the tank 10 in the direction of arrow marks C from the inlets 4-1 to 4-N, under pressure provided by pumps 13, generates a whirlpool along the external circumference of the partition 7, as indicated by arrows A (Figs 3 and 5). The whirlpool stirs the coolant 3 reserved or held in the reservoir tank 10. The stirred coolant 3 passes through through holes 7A (Fig. 5) provided typically at the upper part of the partition 7 as indicated by arrows K (Fig. 5) and then flows into the centre 2A. The coolant 3 passes through the strainer 5 and is output to the feed pipes 11A-1 to 11A-N as indicated by arrow marks B via the outlets 5-1 to 5-N.

With such structure, even if temperature of coolant 3 returned from one of the inlets is extremely high, temperature of the output coolant is made uniform or more uniform since such high temperature coolant is sufficiently mixed with coolant returned from the other inlets.

A coupler 9 (Figs. 4 and 5) provided in parallel to the outlets 5-1 to 5-N is connected with a pipe for checking the coolant 3 output from the outlets 5-1 to 5-N, as required.

In above embodiment a cylindrical tank has been referred to. However, it is apparent that embodiments of the present invention can employ other tank shapes, for example square or square section.

As explained above, an embodiment of the present invention can provide greater uniformity of temperature of coolant output from a plurality of outlets, by stirring and mixing coolant reserved or held in the reservoir tank vessel with flow of coolant returned from a plurality of inlets. As a result, nonuniformity of cooling efficiency for electronic devices due to nonuniformity of temperature of coolant output from a plurality of outlets can be prevented or reduced, so that each of the electronic devices can be operated stably with predetermined cooling efficiency.

A reservoir tank in accordance with an embodiment of the present invention, for employment in a liquid cooling system, is provided with a plurality of outlets for feeding coolant out and a plurality of inlets to which coolant returns after, for example, cooling electronic devices. The outlets are provided towards the centre of a bottom or base of the tank and the inlets are provided outwardly of (the external circumference of) the outlets. The incident angles of the inlets, for delivery of coolant into the tank, are inclined from the vertical line of tank so that the coolant generates a whirlpool around the vertical axis of tank.

A cylindrical partition may be provided between the centre portion of the bottom or base, which is provided with the inlets, and the circumferential or outer portion, which is provided with the outlets, so as to prevent there arising a short coolant flow path from an inlet to an outlet. In this case, holes may be provided in the partition so that coolant stirred or circulated outside partition flows to the outlets therethrough. In such a structure, the coolant is sufficiently stirred or circulated in the tank even if temperature of coolant returning to the tank is different at each inlet. Thereby, temperature of coolant fed out from the outlets is kept at a uniform or more uniform temperature; therefore, uniform or more uniform cooling of the electronic devices can be realised.

## Claims

1. A tank for containing coolant (3), comprising:-
a plurality of outlets (5-1,...,5-N) for feeding said coolant out of the tank, said outlets being located at a central portion (2A) of a bottom or base (2) of said tank, and
a plurality of inlets (4-1,...,4-N) for returning coolant into said tank, said inlets being located outwardly of said central portion, said inlets being directed so as to be slanted or inclined with respect to a vertical axis of the tank, said axis being a line extending perpendicularly to the base or bottom of the tank, so as to generate a whirlpool coaxially around an axis, for example a vertical axis, of said tank.

2. A tank as claimed in claim 1, wherein said tank is in the form of a cylinder rising vertically with respect to the base or bottom (2).

3. A tank as claimed in claim 1 or 2, further comprising a strainer (6) for straining coolant to be fed out of the tank.

4. A tank as claimed in claim 1, 2 or 3, further comprising a partition (7) mounted on said bottom or base of the tank, separating said central portion from a more outward portion, whereby a predetermined coolant flow distance, from inlets to outlets, is provided.

5. A tank as claimed in claim 4, wherein the partition has the form of a cylinder rising vertically with respect to the base or bottom.

6. A tank as claimed in claim 4 or 5, wherein the partition comprises a hole or aperture (7A) for allowing coolant in a zone outward of said partition to flow therethrough into a zone inside said partition.

7. A liquid cooling system, for cooling a plurality of electronic components, such as semiconductor devices, through coolant flow, comprising a plurality of cooling units (16) and a coolant reservoir tank (10), the cooling units being connected to the tank by respective feed and return pipes (11A, 11B) for coolant flow from and to the tank, which feed and return pipes are connected to respective outlets (5-1,....,5-N) and inlets (4-1,...,4-N) of the tank, the outlets being located within a central portion (2A) of a bottom or base (2) of the tank and the inlets being located outwardly of the central portion of the bottom or base and being directed so as to be slanted or inclined with respect to a vertical axis extending perpendicularly to the bottom or base into the tank and to direct returning coolant flow, to the tank, to generate a whirlpool effect around the axis extending from the bottom or base into the tank.

## Patentansprüche

1. Ein Behälter zum Aufnehmen von Kühlmittel (3) mit:-
einer Vielzahl von Auslaßöffnungen (5-1, ..., 5-N) zum Hinausführen des genannten Kühlmittels aus dem Behälter, welche Auslaßöffnungen in einem Mittelabschnitt (2A) eines Unterteils oder Bodens (2) des genannten Behälters angeordnet sind, und
einer Vielzahl von Einlaßöffnungen (4-1, ..., 4-N) zum Zurückführen von Kühlmittel in den genannten Behälter, welche Einlaßöffnungen außerhalb des genannten Mittelabschnittes angeordnet sind und so gerichtet sind, um bezüglich einer vertikalen Achse des Behälters schräg oder geneigt zu sein, welche Achse eine Linie ist, die sich senkrecht zu dem Boden oder Unterteil des Behälters erstreckt, um koaxial um eine Achse, zum Beispiel eine vertikale Achse, des genannten Behälters einen Wirbel zu erzeugen.

2. Ein Behälter nach Anspruch 1, bei dem der genannte Behälter in der Form eines Zylinders ist, der bezüglich des Bodens oder Unterteils (2) vertikal emporragt.

3. Ein Behälter nach Anspruch 1 oder 2, der ferner einen Filter (6) zum Filtern von Kühlmittel umfaßt, das aus dem Behälter hinauszuführen ist.

4. Ein Behälter nach Anspruch 1, 2 oder 3, der ferner eine Trennwand (7) umfaßt, die auf dem genannten Unterteil oder Boden des Behälters montiert ist und den genannten Mittelabschnitt von einem weiter außenliegenden Abschnitt trennt, wodurch ein vorbestimmter Kühlmittelflußabstand von Einlaßöffnungen zu Auslaßöffnungen vorgesehen ist.

5. Ein Behälter nach Anspruch 4, bei dem die Trennwand die Form eines Zylinders hat, der bezüglich des Bodens oder Unterteils vertikal emporragt.

6. Ein Behälter nach Anspruch 4 oder 5, bei dem die Trennwand ein Loch oder eine öffnung (7A) umfaßt, um Kühlmittel in einer Zone außerhalb der genannten Trennwand in eine Zone innerhalb der genannten Trennwand dahindurch fließen zu lassen.

7. Ein Flüssigkeitskühlsystem zum Kühlen einer Vielzahl von elektronischen Bauelementen, wie Halbleiteranordnungen, durch Kühlmittelfluß, das eine Vielzahl von Kühleinheiten (16) und einen Kühlmittelvorratsbehälter (10) umfaßt, wobei die Kühleinheiten mit dem Behälter durch entsprechende Zuführungs- und Rückführungsröhren (11A, 11B) für einen Kühlmittelfluß von und zu dem Behälter verbunden sind, welche Zuführungs- und Rückführungsrohren mit entsprechenden Auslaßöffnungen (5-1, ..., 5-N) und Einlaßöffnungen (4-1, ..., 4-N) des Behälters verbunden sind, wobei die Auslaßöffnungen innerhalb eines Mittelabschnittes (2A) eines Unterteils oder Bodens (2) des Behälters angeordnet sind und die Einlaßöffnungen außerhalb des Mittelabschnittes des Unterteils oder Bodens angeordnet sind und so gerichtet sind, um bezüglich einer vertikalen Achse, die sich senkrecht zu dem Unterteil oder Boden in den Behälter erstreckt, schräg oder geneigt zu sein, um einen zum Behälter zurücklaufenden Kühlmittelfluß zu leiten, um einen Wirbeleffekt um die Achse herum zu erzeugen, die sich von dem Unterteil oder Boden in den Behälter erstreckt.

## Revendications

1. Réservoir pour contenir une matière réfrigérante (3), comprenant :
une pluralité d'orifices de sortie (5-1,...,5-N) pour sortir ladite matière réfrigérante du réservoir, lesdits orifices de sortie étant situés dans une partie centrale (2A) du fond ou de la base (2) dudit réservoir, et
une pluralité d'orifices d'entrée (4-1,...,4-N) pour renvoyer la matière réfrigérante dans ledit réservoir, lesdits orifices d'entrée étant situés à l'extérieur de ladite partie centrale, lesdits orifices d'entrée étant dirigés de manière à être obliques ou inclinés par rapport à un axe vertical du réservoir, ledit axe étant une ligne s'étendant perpendiculairement à la base ou au fond du réservoir, de manière à générer un remous coaxialement autour d'un axe, par exemple un axe vertical, dudit réservoir.

2. Réservoir selon la revendication 1, dans lequel ledit réservoir a la forme d'un cylindre s'élevant verticalement par rapport à la base ou au fond (2).

3. Réservoir selon l'une quelconque des revendications 1 et 2, comprenant en outre un filtre (6) pour filtrer la matière réfrigérante à sortir du réservoir.

4. Réservoir selon l'une quelconque des revendications 1 à 3, comprenant en outre une cloison (7) montée sur ledit fond ou ladite base du réservoir, séparant ladite partie centrale d'une partie plus extérieure, une distance prédéterminée de circulation de la matière réfrigérante, des orifices d'entrée aux orifices de sortie, étant ainsi obtenue.

5. Réservoir selon la revendication 4, dans lequel la cloison a la forme d'un cylindre s'élevant verticalement par rapport à la base ou au fond.

6. Réservoir selon l'une quelconque des revendications 4 et 5, dans lequel la cloison comprend un trou ou une ouverture (7A) pour permettre le passage de la matière réfrigérante dans une zone à l'extérieur de ladite cloison par celle-ci jusque dans une zone à l'intérieur de ladite cloison.

7. Système de refroidissement liquide, pour refroidir une pluralité de composants électroniques, tels que des dispositifs à semiconducteurs, par circulation d'un fluide réfrigérant, comprenant une pluralité d'unités de refroidissement (16) et un réservoir de fluide réfrigérant (10), les unités de refroidissement étant connectées au réservoir par des tuyaux d'alimentation et de retour (11A, 11B) pour la circulation du fluide réfrigérant à partir du et vers le réservoir, ces tuyaux d'alimentation et de retour étant connectés à des orifices de sortie (5-1,...,5-N) et des orifices d'entrée (4-1,...,4-N) respectifs du réservoir, les orifices de sortie étant situés dans une partie centrale (2A) du fond ou de la base du réservoir et les orifices d'entrée étant situés à l'extérieur de la partie centrale du fond ou de la base et étant dirigés de manière à être obliques ou inclinés par rapport à un axe vertical s'étendant perpendiculairement au fond ou à la base dans le réservoir et à diriger la circulation du fluide réfrigérant de retour vers le réservoir, pour générer un effet de remous autour de l'axe s'étendant du fond ou de la base jusque dans le réservoir.
